# FASCICULE DE BREVET EUROPEEN

(11) **EP 2 579 321 B1**
(45) Date de publication et mention de la délivrance du brevet: **24.02.2016**
(21) Numéro de dépôt: 12187270.9
(22) Date de dépôt: 04.10.2012
(51) Int. Cl.: H01L 31/0236, H01L 21/3065, H01L 21/308

(54) **Procédé de fabrication d'un substrat semi-conducteur structuré**
Herstellungsverfahren eines strukturierten Halbleitersubstrats
Method of manufacturing a structured semi-conductor substrate

(30) Priorité: 06.10.2011 FR 1159027
(43) Date de publication de la demande: 10.04.2013
(73) Titulaire: Altis Semiconductor, 91105 Corbeil Essonnes Cedex (FR)
(72) Inventeur: Baltzinger, Jean-Luc, 91210 DRAVEIL (FR); Copinet, Didier, 91540 MENNECY (FR); Demarest, Patrick, 77590 BOIS LE ROI (FR)
(74) Mandataire: Peguet, Wilfried

(56) Documents cités:
- WO-A1-2010/109692
- WO-A2-02/073668
- GOMEZ SERGI ET AL: "Etching of high aspect ratio features in Si using SF6/O2/HBr and SF6/O2/Cl2 plasma", JOURNAL OF VACUUM SCIENCE AND TECHNOLOGY: PART A, AVS /AIP, MELVILLE, NY., US, vol. 23, no. 6, 24 octobre 2005 (2005-10-24), pages 1592-1597, XP012074179, ISSN: 0734-2101, DOI: 10.1116/1.2049303

## Description

La présente invention se rapporte à un procédé de fabrication d'un substrat semi-conducteur structuré.

Elle s'applique typiquement, mais non exclusivement, au domaine de la microélectronique pour la fabrication de composants électroniques tels que par exemple des photodétecteurs, des modulateurs, des émetteurs de lumière, des guides d'ondes, des filtres de bandes interdites photoniques, des amplificateurs optiques, des interconnecteurs optiques, des circuits intégrés, ...etc

Certains types de photodétecteurs, comme d'autres composants électroniques, sont classiquement fabriqués à base de silicium par le procédé CMOS pour « *Complementary Metal Oxide Semiconductor ».*

Les photodétecteurs actuels fabriqués à partir d'un substrat de silicium sont destinés à absorber environ 60% de la lumière visible, et ont classiquement des rendements d'absorption plus faibles dans le domaine de l'infrarouge. Leur domaine d'application reste donc limité.

De nouvelles structures sont apparues afin d'élargir le champ d'application de ce type de technologie à un spectre plus large de longueurs d'ondes incluant le domaine de l'infrarouge : on parle de substrat de silicium micro-structuré, bien connu sous l'anglicisme « *black silicon* » (ce silicium étant absorbant, il paraît noir).

A ce titre, on peut citer le document US 7 390 689 qui décrit un procédé pour obtenir un substrat micro-structuré. Ce procédé consiste à irradier la surface plane d'un substrat de silicium par des impulsions laser, de sorte à obtenir un substrat de silicium avec une structure comportant des cavités à parois inclinées, la section inférieure des cavités étant inférieure à la section supérieure des cavités (la cavité se rétrécissant donc en profondeur).

Toutefois, ce type de procédé présente l'inconvénient d'être complexe à mettre en oeuvre et d'être difficilement applicable au niveau industriel, avec une grande productivité.

Le document WO-A-2010 109 692 (EP-A-2 413 374) décrit un procédé de texturation d'une surface de semiconducteur utilisant un masque et une gravure humide.

Le but de la présente invention est de pallier les inconvénients des techniques de l'art antérieur en proposant notamment un procédé de fabrication d'un substrat semi-conducteur structuré simple et économique, pouvant être appliqué avec une très bonne productivité.

La présente invention a pour objet un procédé de fabrication d'un substrat semi-conducteur structure conformément à la revendication 1.

La présente invention permet avantageusement de fournir un procécé de fabrication d'un substrat structuré, ou plus particulièrement d'un substrat micro-structuré, facile à mettre en oeuvre, et applicable à une échelle industrielle.

En outre, le substrat semiconducteur structuré de l'invention garantie une excellente absorption optique, notamment pour des longueurs d'ondes pouvant aller de 600 à 2000 nanomètres (nm).

On entend par « substrat structuré » un substrat dont la surface comporte des cavités à parois inclinées, formant ainsi un réseau de cavités.

Le réseau de cavités comprend plus particulièrement plusieurs alignements de cavités.

Lesdites cavités comprennent une partie inférieure et une partie supérieure. La distance maximale séparant la partie inférieure de la partie supérieure définie la profondeur des cavités.

Les cavités peuvent être en forme de « U » ou bien en forme de « V ». Lorsque les cavités sont en forme de « U », la section de la partie inférieure des cavités est sensiblement égale à la section de la partie supérieure desdites cavités, de sorte que la section des cavités reste constante sur toute leur profondeur. De ce fait, elles forment un ensemble sensiblement homogène dont l'alternance entre les parties supérieures et inférieures des cavités définit une structure dite «en créneaux ». En d'autres termes, les portions résiduelles de matériau semi-conducteur (i.e. matériau semi-conducteur non éliminé lors des étapes i à iv) constitutives des parois inclinées desdites cavités en forme de « U » peuvent être de forme rectangulaire.

Lorsque les cavités sont en forme de « V », la section de la partie inférieure des cavités est inférieure à la section de la partie supérieure desdites cavités, de sorte que la section des cavités décroît avec la profondeur. De ce fait, elles forment un ensemble sensiblement homogène dont l'alternance entre les parties supérieures et inférieures des cavités définit une structure dite «en dents de scies» ou «en sinusoïde ». En d'autres termes, les portions résiduelles de matériau semi-conducteur (i.e. matériau semi-conducteur non éliminé lors des étapes i à iv) constitutives des parois inclinées desdites cavités en forme de « V » peuvent être de forme conique ou triangulaire.

Le substrat structuré de la présente invention est plus particulièrement un substrat micro-structuré, puisque les domaines d'application de ce type de substrat appartiennent à la microélectronique.

La profondeur des cavités à parois inclinées peut ainsi être de l'ordre de quelques dizaines de micromètres, ou inférieure à dix micromètres.

Pour des longueurs d'ondes allant de 600 nm à 1000 nm, le substrat structuré selon la présente invention permet avantageusement d'avoir une absorption optique d'au moins 70%, de préférence d'au moins 80%, de préférence d'au moins 90%, et de façon particulièrement préférée d'au moins 95%.

Pour des longueurs d'ondes allant de 1200 nm à 2000 nm, le substrat structuré selon la présente invention permet avantageusement d'avoir une absorption optique d'au moins 10%, et de préférence d'au moins 15%.

Dans la présente invention, l'absorption optique d'un substrat semiconducteur peut être facilement déterminée en utilisant l'éllipsométrie dans le visible et dans l'infrarouge, cette technique étant bien connue de l'homme du métier.

### Eta pe i

La surface du matériau semi-conducteur de l'étape i sur laquelle est déposée la couche sacrificielle est de préférence une surface sensiblement plane.

Le matériau semi-conducteur comprend notamment une face supérieure et une face inférieure, la face supérieure étant sensiblement parallèle à la face inférieure. La face supérieure est notamment une face sensiblement plane.

L'épaisseur du matériau semi-conducteur est de préférence suffisamment importante pour pouvoir garantir au substrat semi-conducteur structuré une bonne rigidité à la fin du procédé de fabrication. Par exemple, elle peut être comprise entre 50 et 900 µm.

Le matériau semi-conducteur peut être quant à lui choisi parmi le silicium et le germanium. On préférera utiliser du silicium, et notamment du silicium monocristallin.

Le matériau semi-conducteur utilisé à l'étape i peut comprendre un ou des éléments dopants de type N ou de type P. Les types de dopage sont bien connus de l'homme du métier. Les éléments dopants du type N sont généralement choisis parmi les atomes ayant cinq électrons de valence, comme ceux de la colonne 15 (VA) du tableau périodique des éléments. A titre d'exemple, on peut citer le phosphore (P), l'arsenic (As) ou l'antimoine (Sb). Les éléments dopants du type P sont généralement choisis parmi les atomes trivalents, comme ceux de la colonne 13 (IIIA) du tableau périodique des éléments. A titre d'exemple, on peut citer le bore (B).

Lorsque le matériau semi-conducteur est dopé par un élément de type N et/ou P, la concentration en élément(s) dopant(s) au sein du matériau semi-conducteur peut aller de 1.10¹² à 1,5.10¹⁵ atomes/cm³.

La couche sacrificielle de l'invention peut être une couche électriquement conductrice et/ou une couche électriquement isolante (i.e. une couche diélectrique).

Dans un mode de réalisation préféré, la couche sacrificielle est une couche électriquement isolante choisie parmi une couche d'un oxyde et une couche d'un nitrure.

A titre d'exemple, la couche d'oxyde peut être une couche d'oxyde de silicium (SiO₂), et la couche de nitrure peut être une couche de nitrure de silicium (Si₃N₄).

La couche sacrificielle peut être déposée par des procédés bien connus de l'homme du métier, comme par exemple par un dépôt chimique en phase vapeur, notamment à basse pression (LPCVD).

Selon une première variante, la couche sacrificielle de type SiO₂ peut être obtenue par dépôt gazeux sous basse pression (e.g. LPCVD) de TétraEthylOrthoSilicate (TEOS) de formule Si(OC₂H₅)₄ sur la surface du matériau semi-conducteur.

Selon une deuxième variante, la couche sacrificielle de type SiO₂ peut être obtenue tout d'abord par dépôt gazeux sous basse pression (e.g. LPCVD) d'une couche de polysilicium sur la surface du matériau semi-conducteur, puis par oxydation de ladite couche de polysilicium.

### Etape ii

La gravure de l'étape ii consiste à retirer au moins en partie la couche sacrificielle formée à l'étape i, de sorte à former des îlots de couche sacrificielle à la surface du matériau semi-conducteur. Ainsi, lorsque la gravure de l'étape ii est terminée, la couche sacrificielle n'est pas retirée en totalité puisqu'il reste lesdits ilots de couche sacrificielle. En outre, la gravure de l'étape ii permet de ne sensiblement pas retirer de matériau semi-conducteur.

Ainsi, la surface du matériau semi-conducteur sur laquelle a été déposée la couche sacrificielle, comporte, après l'étape ii, des zones non protégées (i.e. zones non recouvertes) par des îlots de couche sacrificielle ainsi que des zones protégées (i.e. zones recouvertes) par des îlots de couche sacrificielle.

La distance séparant deux îlots directement adjacents peut être d'au plus 10 micromètres (µm), de préférence d'au plus 5 µm, et de façon particulièrement préférée de l'ordre de 1 à 2 µm.

La gravure de l'étape ii peut être une gravure essentiellement physique, qui est notamment une gravure du type anisotrope (i.e. gravure anisotropique).

Plus particulièrement, cette gravure essentiellement physique est une gravure ionique réactive.

Selon une première variante, la couche sacrificielle peut être gravée à l'aide d'un plasma constitué à partir d'un mélange gazeux HBr / NF₃ / O₂.

Selon une deuxième variante, la couche sacrificielle peut être gravée à l'aide d'un plasma constitué à partir d'un gaz fluoré, tel que par exemple du tétrafluorure de carbone (CF₄).

Toutefois, il est préférable d'arrêter cette gravure avant que ledit plasma constitué à partir d'un gaz fluoré n'attaque le matériau semi-conducteur. Des systèmes de détection de fin de gravure bien connus de l'homme du métier, tels que la spectroscopie optique, permettent de détecter facilement, par analyse des espèces chimiques présentes dans le plasma, que l'on passe par exemple de la gravure de la couche sacrificielle à une gravure du matériau semi-conducteur.

Selon une troisième variante, la couche sacrificielle peut être gravée selon les étapes successives suivantes :
- déposer une couche de résine photosensible sur la couche sacrificielle,
- réaliser une photolithographie (e.g. exposition à travers un masque qui déterminera la géométrie des îlots, puis développement des zones exposées) pour former des îlots de protection de résine photosensible,
- graver la couche sacrificielle (non protégée par lesdits îlots de protection de résine photosensible) à l'aide d'un plasma constitué a partir d'un gaz fluoré tel que par exemple du tétrafluorure de carbone (CF₄), pour former des îlots de couche sacrificielle protégés par lesdits îlots de protection de résine photosensible, et
- délaquer (i.e. « *stripping* » en anglais) des îlots de protection de résine photosensible.

### Etape iii

La gravure de l'étape iii consiste à retirer au moins en partie le matériau semi-conducteur de l'étape ii, non recouvert par les îlots de couche sacrificielle : lesdits ilots de couche sacrificielle servent ainsi de protection ou de « masque » aux parties de matériau semi-conducteur qu'ils recouvrent. Cette étape de gravure permet notamment de former des cavités à parois inclinées, dont les parties supérieures sont recouvertes par lesdits îlots.

Cette étape iii est réalisée en présence d'oxygène de sorte à déposer une couche d'un oxyde à la surface du matériau semi-conducteur.

En effet, durant cette étape, et grâce à la présence d'oxygène, une couche d'un oxyde se dépose à la surface du matériau semi-conducteur, notamment sur les parois inclinées desdites cavités, formées pendant la gravure de l'étape iii. Ce dépôt d'oxyde permet avantageusement d'obtenir des cavités plus ou moins profondes.

La profondeur et la forme des cavités peuvent ainsi être modulées par le dépôt de la couche d'oxyde en fonction de la quantité d'oxygène présente pendant l'étape de gravure iii.

Ainsi, cette étape permet de former un matériau semi-conducteur structuré, notamment un matériau semi-conducteur micro-structuré.

Lorsque la gravure de l'étape iii est terminée, les îlots de la couche sacrificielle ne sont sensiblement pas altérés, seul le matériau semi-conducteur est gravé, mais il n'est bien entendu pas retiré en totalité.

La mise en oeuvre de cette étape de gravure dépend de deux paramètres, à savoir la vitesse de gravure et le temps de gravure. Ainsi, l'homme du métier pourra faire varier au moins un de ces deux paramètres. Par exemple, il pourra :
a. jouer sur la différence de vitesse de gravure entre la couche sacrificielle et le substrat semi-conducteur,
b. jouer sur le temps de gravure qui détermine la profondeur des cavités,
c. jouer sur les paramètres a et b.

De préférence, à l'étape iii, la vitesse d'attaque de gravure de la couche sacrificielle, et plus particulièrement des îlots de couches sacrificielles, est inférieure à la vitesse d'attaque de gravure du matériau semi-conducteur, et de préférence la vitesse d'attaque de gravure de la couche sacrificielle est dix fois inférieure à la vitesse d'attaque de gravure du matériau semi-conducteur.

La gravure de l'étape ii est une gravure sèche, qui est notamment une gravure du type anisotrope (i.e. gravure anisotropique), et de préférence une gravure plasma de type ionique réactive.

On peut citer comme gravure sèche, une gravure réalisée par un plasma constitué à partir d'un mélange gazeux HBr / NF₃ / O₂, ou par un plasma constitué à partir d'un mélange gazeux SF₆ / O₂.

### Etape iv

L'étape iv permet d'éliminer au moins en partie, de préférence en totalité, les ilots de couche sacrificielle ainsi que la couche d'oxyde présents à la surface du matériau semi-conducteur obtenu à l'étape iii, pour former ledit substrat structuré.

En outre, l'étape iv permet de ne sensiblement pas retirer de matériau semi-conducteur.

On utilise classiquement une gravure chimique humide à l'aide d'une solution d'acide fluorhydrique (HF).

Le substrat structuré ainsi formé est prêt à être utilisé dans des étapes ultérieures de dopage, de traitement thermique, ...etc.

Comme défini précédemment, le substrat structuré de l'invention est notamment un substrat dont la surface est sensiblement plane et comporte des cavités à parois inclinées, formant ainsi un réseau de cavités.

Lesdites cavités comprennent une partie inférieure et une partie supérieure. La distance maximale séparant la partie inférieure de la partie supérieure définie la profondeur des cavités.

La distance maximale séparant deux parois inclinées dans la partie supérieur des cavités peut être d'au plus 10 µm, de préférence d'au plus 5 µm, et de façon particulièrement préférée de l'ordre de 1 à 2 µm.

De façon particulièrement avantageuse, le matériau semi-conducteur initialement utilisé dans l'étape i a été éliminé à plus de 50% en volume, de préférence à plus de 70% en volume, de préférence à plus de 90% en volume, et de façon particulièrement préférée à plus de 95% en volume, pour former lesdites cavités, et ainsi obtenir le substrat semi-conducteur structuré de l'invention.

Ce pourcentage dit « d'évidement » permet de garantir une excellente absorption optique à des longueurs d'ondes comprises notamment entre 600 et 2000 nm.

De façon particulièrement avantageuse, le substrat semi-conducteur structuré, obtenu après l'étape iv, comprend une face supérieure dite structurée, cette face supérieur structurée comportant des portions de surface du matériau semi-conducteur de l'étape i. Ces portions de surface correspondent à la partie supérieure des cavités.

La face supérieure structurée peut alors comprendre au plus 50% en surface du matériau semiconducteur, de préférence au plus 30% en surface du matériau semiconducteur, de préférence au plus 10% en surface du matériau semiconducteur, et de façon particulièrement préférée au plus 5% en surface du matériau semiconducteur, pour former lesdites cavités, et ainsi obtenir le substrat semi-conducteur structuré de l'invention.

Le procédé de fabrication d'un substrat structuré selon l'invention peut en outre comprendre l'étape suivante :
v. doper le substrat obtenu à l'étape iv par un élément dopant choisi parmi les éléments de la colonne 16 (i.e. groupe VIA) du tableau périodique, tel que notamment le soufre, le sélénium, et le tellure, ou un de leurs mélanges.

Ladite étape v permet avantageusement d'améliorer significativement l'absorption optique du substrat semiconducteur structuré de l'invention, notamment pour les longueur d'ondes comprises entre 1200 et 2000 nm.

Selon une première variante, le dopage de l'étape v peut être réalisé par implantation ionique dudit élément dopant au sein du substrat obtenu à l'étape iv. Cette technique consiste à bombarder par un faisceau d'ions dudit élément dopant, la surface du substrat structuré obtenu à l'étape iv.

Selon une seconde variante, le dopage de l'étape v peut être réalisé par diffusion dudit élément dopant au sein du substrat obtenu à l'étape iv. Le dopage est typiquement effectué dans un four, à une température comprise entre 850 °C et 1150 °C.

Que ce soit la première variante ou la seconde variante, ces deux méthodes de dopage sont bien connues de l'homme du métier.

Dans un mode de réalisation particulier, une fois l'étape v réalisée, la concentration en élément dopant au sein du matériau semi-conducteur peut aller de 1.10¹⁶ à 1.10²⁰ atomes/cm³.

Le procédé de fabrication d'un substrat structuré selon l'invention peut en outre comprendre l'étape suivante (postérieure à l'étape v) :
vi. réaliser un traitement thermique pour activer électriquement l'élément dopant au sein du substrat de l'étape v.

L'étape vi de traitement thermique est une étape dite de « cuisson », mieux connue sous l'anglicisme « *anneal* », cette étape est notamment mise en oeuvre lorsque la première variante de l'étape v (cf. dopage par implantation ionique) a été réalisée. Cette étape permet avantageusement d'activer électriquement les éléments dopant implantés à l'étape v, et de reconstruire le réseau cristallin du silicium qui est susceptible d'avoir été endommagé lors de l'étape v.

Elle favorise ainsi la répartition de l'élément dopant au sein du substrat structuré.

Elle peut notamment s'effectuer à une température comprise entre 500°C et 1200°C (bornes incluses), et de préférence entre 800 et 1000°C (bornes incluses). A titre d'exemple, l'étape de traitement thermique peut être du type recuit thermique classique à une température d'environ 800°C pendant environ 1h, ou bien du type recuit thermique rapide (bien connu sous l'anglicisme « *Rapid Thermal Processing* (RTP) ») à une température d'environ 1000°C pendant quelques secondes.

D'autres caractéristiques et avantages de la présente invention apparaîtront à la lumière des exemples qui vont suivre en référence aux figures annotées, lesdits exemples et figures étant donnés à titre illustratif et nullement limitatif.

Les figures 1 à 4 représente une vue schématique en coupe longitudinale d'un substrat semi-conducteur fabriqué selon le procédé de l'invention.

La figure 5 représente l'évolution de l'absorption optique (%) en fonction de la longueur d'ondes (nm) pour différents substrats semi-conducteur selon l'invention (C2 et C3) et selon l'art antérieur (C1).

La figure 6 représente une image obtenue par microscopie électronique à balayage (MEB), avec un grossissement fois 10000 de la surface d'un substrat semiconducteur structuré obtenu selon le procédé de l'invention.

Pour des raisons de clarté, les mêmes éléments ont été désignés par des références identiques. De même, seuls les éléments essentiels pour la compréhension de l'invention ont été représentés de manière schématique, et ceci sans respect de l'échelle.

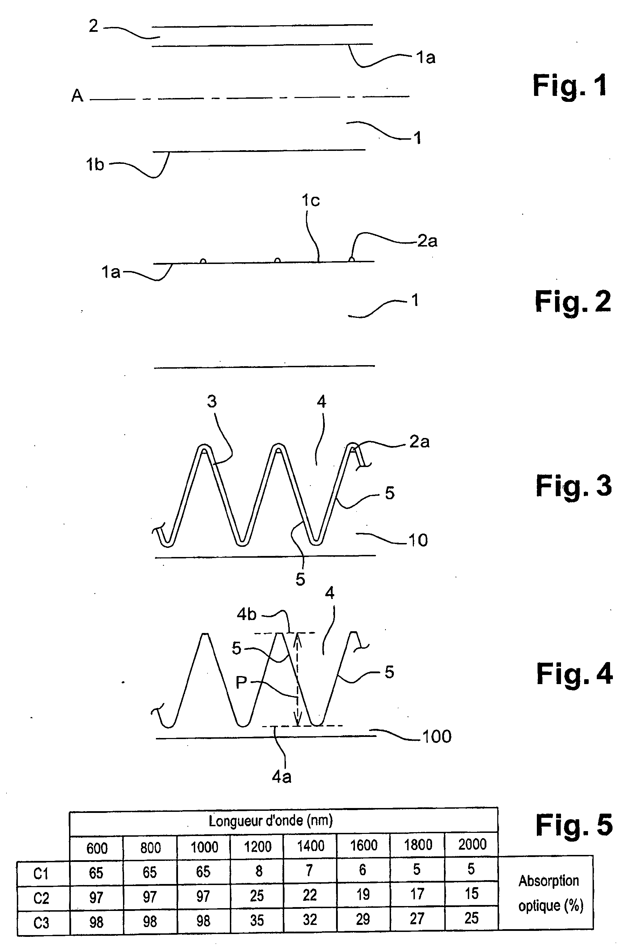

Les termes « partie inférieure » et « partie supérieure » ne sont nullement limitatifs dans le cadre de la présente invention, et permettent notamment de faciliter la compréhension de l'invention au regard du positionnement du substrat tel que représenté sur les figures 1 à 4 de l'invention.

La figure 1 représente une vue schématique en coupe longitudinale d'une couche d'un matériau 1 de silicium monocristallin allongé selon un axe longitudinal A. Il comporte une face supérieure 1a et une face inférieure 1b, la face supérieure 1a étant sensiblement plane.

Ces deux faces 1a et 1b sont sensiblement parallèles entre elles, et sont distantes d'une épaisseur d'environ 630 µm (i.e. épaisseur de la couche du matériau de silicium monocristallin).

Sur la surface supérieure 1a est déposée une couche sacrificielle 2 électriquement isolante de type dioxyde de silicium par dépôt chimique à basse pression (LPCVD) avec une phase vapeur de TEOS, à basse pression (étape i).

Plus particulièrement, le dépôt de dioxyde de silicium est réalisé dans un four référencé Tokyo Electron Limited, de type ALPHA 8S, à une température de 650°C pendant 1h25, avec un débit de 100 cm³/minute de TEOS sous une pression de 0,25 Torr. La couche sacrificielle 2 obtenue a une épaisseur d'environ 130 nm.

Une fois la couche sacrificielle 2 déposée, on réalise une première gravure (étape ii) consistant à retirer au moins en partie la couche sacrificielle 2, sans toucher au matériau 1 de silicium monocristallin, de sorte à former des îlots 2a de couche sacrificielle sur la surface 1a du matériau 1 de silicium monocristallin, tels que représentés sur la figure 2. La surface 1a du matériau de silicium monocristallin comporte ainsi des zones le qui ne sont pas protégées ou recouvertes par des îlots de couche sacrificielle.

Cette première gravure est une gravure ionique réactive réalisée à l'aide d'un plasma constitué à partir d'un mélange gazeux HBr / NF₃ / O₂.

Une fois les ilots 2a de couche sacrificielle formés, on réalise une deuxième gravure (étape iii) consistant à retirer au moins en partie le matériau 1 de silicium monocristallin des zones 1c non protégées par lesdits îlots de couche sacrificielle, et sans toucher aux îlots 2a de couche sacrificielle, de sorte à former un matériau 10 de silicium monocristallin micro-structuré comportant des cavités 4 à parois inclinées 5, tel que représenté sur la figure 3.

Dans cette étape, la vitesse d'attaque de gravure de la couche 2 de dioxyde de silicium (cf. ilots de couche sacrificielle) est au moins dix fois inférieure à la vitesse de gravure du matériau 1 de silicium monocristallin.

Cette deuxième gravure est une gravure sèche consistant à placer le matériau de silicium monocristallin comportant lesdits ilots de couche sacrificielle, dans un réacteur pour le traiter avec un plasma d'un mélange gazeux HBr / NF₃ / O₂. Lors de cette deuxième gravure, une couche 3 d'un oxyde de silicium se dépose simultanément sur la surface des parois inclinées formées (i.e. croissance du dépôt d'oxyde de silicium). La couche de dioxyde de silicium ainsi déposée est de l'ordre de 100 nm (épaisseur atteinte à la fin de la gravure de l'étape iii).

Le matériau 10 de silicium monocristallin micro-structuré est enfin nettoyé (étape iv) des îlots 2a de couche sacrificielle ainsi que de la couche 3 dudit oxyde. Pour ce faire, on utilise une troisième gravure du type gravure chimique humide consistant à immerger le matériau 10 de silicium monocristallin micro-structuré dans une solution d'acide fluorhydrique dilué à 100:1, à température ambiante pendant quelques minutes, typiquement de 2 à 5 minutes, afin d'obtenir le substrat 100 de silicium monocristallin micro-structuré tel que représenté sur la figure 4.

Sur la figure 4, chaque cavité comporte une partie inférieure 4a et une partie supérieure 4b, la distance maximale séparant ces deux parties définissant la profondeur p de ladite cavité. La section inférieure au niveau de la partie inférieure 4a de la cavité 4 est inférieure à la section supérieure au niveau de la partie supérieure 4b de la cavité 4, de sorte à former une cavité en forme de « V » : les cavités se rétrécissent en profondeur.

La profondeur p obtenue après l'étape iv est en moyenne de l'ordre de 10 µm.

Comme l'illustre la figure 4, le matériau semi-conducteur 1 a été éliminé à plus de 90% en volume pour former lesdites cavités 4, et ainsi obtenir le substrat 100 micro-structuré.

En vue de dessus, la face supérieure 4b des cavités du substrat 100 de silicium monocristallin micro-structuré comprend au plus 5% en surface du matériau semiconducteur 1.

Bien entendu, la structure de l'ensemble des cavités formées dans l'épaisseur de la couche de matériau de silicium monocristallin (après l'étape iv) est sensiblement homogène : lesdites cavités ont des dimensions (e.g. profondeur) et des formes (e.g. forme en « V ») sensiblement identiques entre elles.

Le procédé selon l'invention peut être poursuivi en dopant (étape v) le substrat 100 de silicium monocristallin micro-structuré avec du soufre, à l'aide d'un faisceau d'ions soufre (étape non représentée).

Le soufre est ainsi implanté en bombardant la surface du substrat 100 de silicium monocristallin micro-structuré par un faisceau d'ions soufre ionisés (S+), accéléré à 40 kV : la concentration maximale de soufre se trouve ainsi à environ 40 nm de profondeur en partant de la surface bombardée.

Une fois l'étape v réalisée, la concentration obtenue de l'élément dopant au sein du substrat de silicium monocristallin micro-structuré est de l'ordre de 1.10¹⁶ atomes/cm³.

Afin de redonner au matériau silicium sa structure cristalline initiale, ou en d'autres termes reconstituer le réseau cristallin du silicium sous la forme d'un réseau monocristallin, telle qu'elle existait avant l'étape v de dopage, il est nécessaire de le traiter thermiquement. Pour ce faire, on place le substrat 100 de silicium monocristallin micro-structuré et dopé au soufre dans un four, à une température de 800°C pendant 1 heure ou à une température de 1000°C pendant une dizaine de secondes (étape non représentée).

La figure 5 représente l'évolution de l'absorption optique (%) en fonction de la longueur d'ondes (nm) pour différents substrats semi-conducteur selon l'invention (C2 et C3) et selon l'art antérieur (C1).

Les mesures C1 représentent ladite évolution pour un substrat de silicium monocristallin non micro-structuré, avec un dopage au soufre de 1.10¹⁶ atomes/cm³ : seules les étapes v et vi, décrites dans l'exemple ci-avant, ont été effectuées à la surface d'un matériau de silicium monocristallin de surface sensiblement plane.

Les mesures C2 représentent ladite évolution pour un substrat de silicium monocristallin micro-structuré selon le procédé de l'invention, non dopé avec du soufre : seules les étapes i à iv ont été effectuées, telles que décrites dans l'exemple mentionné ci-avant.

Les mesures C3 représentent ladite évolution pour un substrat de silicium monocristallin micro-structuré selon le procédé de l'invention, avec un dopage au soufre de 1.10¹⁶ atomes/cm³ : les étapes i à vi ont été effectuées, telles que décrites dans l'exemple mentionné ci-avant.

Au regard des mesures rassemblées dans le tableau de la figure 5, il apparaît clairement que le substrat semi-conducteur micro-structuré obtenu par le procédé selon l'invention (étapes i à iv) (C2) présente de très bonnes propriétés d'absorption au regard d'un substrat semi-conducteur non micro-structuré (C1), même lorsque ce dernier est dopé avec du soufre. En effet, le substrat C2 présente une absorption comprise entre 15 et 25 % pour des longueurs d'ondes allant de 1200 à 2000 nm, alors que le substrat C1 présente une absorption en dessous de 10 % pour des longueurs d'ondes allant de 1200 à 2000 nm.

On notera également que l'ajout des étapes v et vi au procédé de l'invention (étapes i à iv) (C3) permet d'améliorer de façon significative les propriétés d'absorbance du substrat puisque l'on obtient une absorption comprise entre 25 et 35 % pour des longueurs d'ondes allant de 1200 à 2000 nm.

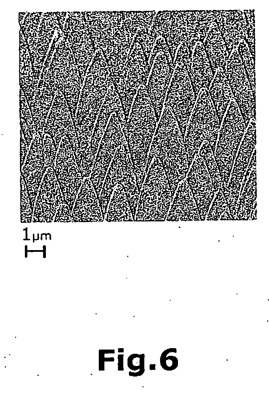

La figure 6 représente une image MEB de la surface d'un substrat semi-conducteur structuré obtenu selon le procédé de l'invention. Cette image représente le substrat semi-conducteur structuré obtenu après la réalisation des étapes i à iv tels que décrites précédemment au regard des figures 1 à 4.

Dans la figure 6, les portions résiduelles de matériau semi-conducteur constitutives des parois inclinées desdites cavités sont de forme conique (i.e. portions coniques), et plus particulière sont de type « cheminée de fée ».

La distance entre les sommets de deux portions coniques directement adjacentes est notamment d'au plus 10 µm, et plus particulièrement ladite distance va de 1 à 5 µm.

## Revendications

1. Procédé de fabrication d'un substrat semi-conducteur structuré (100) pour l'absorption optique comprenant les étapes suivantes :
i. déposer, sur la surface (1a) d'un matériau semi-conducteur (1), une couche sacrificielle (2), différente du matériau semiconducteur,
ii. graver au moins en partie la couche sacrificielle (2) formée à l'étape i, de sorte à former des îlots (2a) de couche sacrificielle à la surface (1a) du matériau semi-conducteur,
iii. graver au moins en partie le matériau semi-conducteur (1) de l'étape ii, au niveau des zones (1c) non protégées par lesdits ilots (2a), de sorte à former un matériau semi-conducteur structuré (10), cette étape iii étant réalisée par gravure sèche en présence d'oxygène de sorte à déposer une couche d'un oxyde (3) à la surface du matériau semi-conducteur, et
iv. éliminer les îlots (2a) de couche sacrificielle et la couche d'oxyde (3), à la surface du matériau semi-conducteur obtenu à l'étape iii, pour former ledit substrat structuré (100).

2. Procédé selon la revendication 1, **caractérisé en ce que** le matériau semi-conducteur est du silicium.

3. Procédé selon la revendication 1 ou 2, **caractérisé en ce que** la couche sacrificielle de l'étape i est choisie parmi une couche d'un oxyde et une couche d'un nitrure.

4. Procédé selon la revendication 3, **caractérisé en ce que** la couche d'oxyde est une couche d'oxyde de silicium (SiO₂).

5. Procédé selon la revendication 3, **caractérisé en ce que** la couche de nitrure est une couche de nitrure de silicium (Si₃N₄).

6. Procédé selon l'une quelconque des revendications 1 à 5, **caractérisé en ce que** la gravure de l'étape ii est une gravure ionique réactive.

7. Procédé selon l'une quelconque des revendications 1 à 6, **caractérisé en ce que** la gravure de l'étape iii est une gravure ionique réactive.

8. Procédé selon l'une quelconque des revendications 1 à 7, **caractérisé en ce que** l'étape iv est réalisée en présence d'une solution d'acide fluorhydrique (HF).

9. Procédé selon l'une quelconque des revendications 1 à 8, **caractérisé en ce que** la gravure de l'étape ii est une gravure anisotropique.

10. Procédé selon l'une quelconque des revendications 1 à 9, **caractérisé en ce que** la gravure de l'étape iii est une gravure anistropique.

11. Procédé selon l'une quelconque des revendications 1 à 10, **caractérisé en ce que** le substrat structuré est un substrat dont la surface comporte des cavités à parois inclinées, formant ainsi un réseau de cavités.

12. Procédé selon l'une quelconque des revendications 1 à 11, **caractérisé en ce qu'**il comprend en outre l'étape suivante :
v. doper le substrat obtenu à l'étape iv par un élément dopant choisi parmi le soufre, le sélénium, et le tellure, ou un de leurs mélanges.

13. Procédé selon la revendication 12, **caractérisé en ce que** la concentration en élément dopant de l'étape v, au sein du matériau semi-conducteur, va de 1.10¹⁶ à 1.10²⁰ atomes/cm³.

14. Procédé selon la revendication 12 ou 13, **caractérisé en ce qu'**il comprend en outre l'étape suivante :
vi. réaliser un traitement thermique pour activer électriquement l'élément dopant au sein du substrat de l'étape v.

15. Procédé selon la revendication 14, **caractérisé en ce que** le traitement thermique de l'étape vi s'effectue à une température comprise entre 500°C et 1200°C (bornes incluses).

## Patentansprüche

1. Verfahren zur Herstellung eines strukturierten Halbleitersubstrats (100) für die optische Absorption, das die folgenden Schritte umfasst:
i. Aufbringen, auf die Oberfläche (1a) eines Halbleitermaterials (1), einer Opferschicht (2), die sich vom Halbleitermaterial unterscheidet,
ii. mindestens teilweises Gravieren der in Schritt i gebildeten Opferschicht (2), um auf der Oberfläche (1a) des Halbleitermaterials Opferschicht-Inseln (2a) zu bilden,
iii. mindestens teilweises Gravieren des Halbleitermaterials (1) von Schritt ii im Bereich der nicht von den Inseln (2a) geschützten Zonen (1c), um ein strukturiertes Halbleitermaterial (10) zu bilden, wobei dieser Schritt iii durch Trockengravur bei Anwesenheit von Sauerstoff durchgeführt wird, um eine Schicht eines Oxids (3) auf der Oberfläche des Halbleitermaterials aufzubringen, und
iv. Entfernen der Opferschicht-Inseln (2a) und der Oxidschicht (3) auf der Oberfläche des Halbleitermaterials von Schritt iii, um das strukturierte Substrat (100) zu bilden.

2. Verfahren nach Anspruch 1, **dadurch gekennzeichnet, dass** das Halbleitermaterial Silizium ist.

3. Verfahren nach Anspruch 1 oder 2, **dadurch gekennzeichnet, dass** die Opferschicht von Schritt i aus einer Schicht eines Oxids und einer Schicht eines Nitrids ausgewählt ist.

4. Verfahren nach Anspruch 3, **dadurch gekennzeichnet, dass** die Oxidschicht eine Siliziumoxidschicht (SiO₂) ist.

5. Verfahren nach Anspruch 3, **dadurch gekennzeichnet, dass** die Nitridschicht eine Siliziumnitridschicht (Si₃N₄) ist.

6. Verfahren nach einem der Ansprüche 1 bis 5, **dadurch gekennzeichnet, dass** die Gravur von Schritt ii eine reaktive Ionengravur ist.

7. Verfahren nach einem der Ansprüche 1 bis 6, **dadurch gekennzeichnet, dass** die Gravur von Schritt iii eine reaktive Ionengravur ist.

8. Verfahren nach einem der Ansprüche 1 bis 7, **dadurch gekennzeichnet, dass** Schritt iv bei Anwesenheit einer Fluorwasserstoffsäurelösung (HF) durchgeführt wird.

9. Verfahren nach einem der Ansprüche 1 bis 8, **dadurch gekennzeichnet, dass** die Gravur von Schritt ii eine anisotrope Gravur ist.

10. Verfahren nach einem der Ansprüche 1 bis 9, **dadurch gekennzeichnet, dass** die Gravur von Schritt iii eine anisotrope Gravur ist.

11. Verfahren nach einem der Ansprüche 1 bis 10, **dadurch gekennzeichnet, dass** das strukturierte Substrat ein Substrat ist, dessen Oberfläche Hohlräume mit geneigten Wänden aufweist, die somit ein Hohlraumnetzwerk bilden.

12. Verfahren nach einem der Ansprüche 1 bis 11, **dadurch gekennzeichnet, dass** es ferner den folgenden Schritt umfasst:
v. Dotieren des in Schritt iv erhaltenen Substrats mit einem dotierenden Element, das aus dem Schwefel, dem Selen und dem Tellur oder einem ihrer Gemische ausgewählt ist.

13. Verfahren nach Anspruch 12, **dadurch gekennzeichnet, dass** die Konzentration von dotierendem Element von Schritt v innerhalb des Halbleitermaterials von 1,10¹⁶ bis 1,10²⁰ Atome/cm³ beträgt.

14. Verfahren nach Anspruch 12 oder 13, **dadurch gekennzeichnet, dass** es ferner den folgenden Schritt umfasst:
vi. Durchführen einer thermischen Behandlung zur elektrischen Aktivierung des dotierenden Elements innerhalb des Substrats von Schritt v.

15. Verfahren nach Anspruch 14, **dadurch gekennzeichnet, dass** die thermische Behandlung von Schritt vi bei einer Temperatur zwischen 500 °C und 1200 °C inklusive (Grenzen inbegriffen) erfolgt.

## Claims

1. A method for manufacturing a structured semiconductor substrate (100) for optical absorption, comprising the following steps:
i. depositing, on the surface (1 a) of a semiconductor material (1), a sacrificial layer (2), different from the semiconductor material,
ii. at least partially etching the sacrificial layer (2) formed in step i, so as to form islands (2a) of sacrificial layer on the surface (1 a) of the semiconductor material,
iii. at least partially etching the semiconductor material (1) of step ii, at zones (1c) not protected by said islands (2a), so as to form a structured semiconductor material (10), this step iii being done by dry etching in the presence of oxygen so as to deposit a layer of oxide (3) on the surface of the semiconductor material, and
iv. eliminating the islands (2a) of sacrificial layer and the oxide layer (3), at the surface of the semiconductor material obtained in step iii, to form said structured substrate (100).

2. The method according to claim 1, **characterized in that** the semiconductor material is silicon.

3. The method according to claim 1 or 2, **characterized in that** the sacrificial layer of step i is chosen from among an oxide layer and nitride layer.

4. The method according to claim 3, **characterized in that** the oxide layer is a layer of silicon oxide (SiO₂).

5. The method according to claim 3, **characterized in that** the nitride layer is a layer of silicon nitride (Si₃N₄).

6. The method according to any one of claims 1 to 5, **characterized in that** the etching of step ii is a reactive ion etching.

7. The method according to any one of claims 1 to 6, **characterized in that** the etching of step iii is a reactive ion etching.

8. The method according to any one of claims 1 to 7, **characterized in that** step iv is carried out in the presence of a hydrofluoric (HF) acid solution.

9. The method according to any one of claims 1 to 8, **characterized in that** the etching of step ii is an anisotropic etching.

10. The method according to any one of claims 1 to 9, **characterized in that** the etching of step iii is an anisotropic etching.

11. The method according to any one of claims 1 to 10, **characterized in that** the structured substrate is a substrate whose surface includes cavities with inclined walls, thus forming a network of cavities.

12. The method according to any one of claims 1 to 11, **characterized in that** it further comprises the following step:
v. doping the substrate obtained in step iv with a doping element chosen from among sulfur, selenium and tellurium, or a mixture thereof.

13. The method according to claim 12, **characterized in that** the concentration of doping element in step v, within the semiconductor material, is from 1.10¹⁶ to 1.10²⁰ atoms/cm³.

14. The method according to claim 12 or 13, **characterized in that** it further comprises the following step:
vi. performing a heat treatment to electrically activate the doping element within the substrate of step v.

15. The method according to claim 14, **characterized in that** the heat treatment of step vi is done at a temperature comprised between 500°C and 1200°C (inclusive).
